# EUROPEAN PATENT SPECIFICATION

(11) **EP 0 404 180 B1**
(45) Date of publication and mention of the grant of the patent: **20.03.1996**
(21) Application number: 90111880.2
(22) Date of filing: 22.06.1990
(51) Int. Cl.: H01L 27/105, H01L 27/06

(54) **Semiconductor integrated circuit and method of making the same**
Integrierte Halbleiterschaltung und Verfahren zu deren Herstellung
Circuit intégré à semi-conducteur et procédé pour sa fabrication

(30) Priority: 22.06.1989 JP 160055/89
(43) Date of publication of application: 27.12.1990
(73) Proprietor: KABUSHIKI KAISHA TOSHIBA, Kawasaki-shi, Kanagawa-ken 210, Tokyo (JP)
(72) Inventor: Taguchi, Minoru, c/o Intellectual Property Div., Minato-ku, Tokyo 105 (JP); Mochizuki, Hiroshi, c/o Intellectual Property Div, Minato-ku, Tokyo 105 (JP)
(74) Representative: Lehn, Werner, Dipl.-Ing.

(56) References cited:
- EP-A- 0 071 010
- US-A- 4 152 715
- US-A- 4 253 168
- PATENT ABSTRACTS OF JAPAN, vol. 6, no. 189 (E-133)[1067], 28th September 1982;& JP-A-57 103 347 (CLARION K.K.) 26-06-1982
- IEEE JOURNAL OF SOLID-STATE CIRCUITS, vol. SC-12, no. 6, December 1977, pages633-637, New York, US; D.A. SEALER et al.: "A dual-differential analog shiftregister with a charge-splitting input and on-chip peripheral circuits"

## Description

The present invention relates to an integrated semiconductor device comprising: a semiconductor substrate of a first conductivity type having a low impurity concentration; first and second expitaxial layer islands of a second conductivity type provided in the semiconductor substrate so as to be exposed to the substrate surface; a buried layer of the second conductivity type having a high impurity concentration the buried layer being provided in the semiconductor substrate and surrounding each of the first and second epitaxial layer islands; a field oxide film formed in the semiconductor substrate so as to surround the periphery of the first and second epitaxial layer islands; and a bipolar transistor formed in the first epitaxial layer island.

Such a device is known from JP-A-57-103347.

The invention also relates to a method of manufacturing an integrated semiconductor device.

IEEE Journal of Solid-State Circuits, Vol. SC-12, No. 6 (1977-12) pp. 633-637 discloses an integrated circuit comprising CCD and MOS elements.

US-A-4253168 discloses integrated circuits comprising CCD, MOD and bipolar transistors.

With development of fine pattern technology in integrated circuits (ICs) or large scale integrated circuits (LSIs), various compact electronic devices having multifunctions and low power consumption have been recently developed. A compact device, which employs a package having many pins and accommodating at least one IC or LSI chip, has been required, and a multi-chip module has been also commercially available.

Further, in a CCD (Charge Coupled Device) type IC, it is easy to increase its integration density and to reduce its power consumption. Therefore, the CCD type IC has been used for solid state image pickup devices such as line sensors, area sensors, etc, and CCD delay devices. In a CCD type LSI used for video signal processing of TV receivers or video tape recorders, it has been performed to mount a plurality of CCD type and bipolar type LSI chips on a single package.

At any rate, however, the multi-chip techniques described above have the following disadvantages.
(1) Since discrete ICs are combined, it is difficult to constitute a device corresponding to a desired system.
(2) Since electrodes among chips are electrically connected by wire bonding or the like, a high-speed operation of the device cannot be obtained due to long wiring structure.
(3) It is difficult to obtain a compact device by decreasing the number of pins.
(4) Since the package becomes large, reliability of the device is lowered due to cracks of a pellet or deterioration of humidity resistance.
(5) There is a limit to decrease the power consumption of the device.

A CCD type integrated circuit requires a predetermined breakdown voltage. At the same time, for providing CCD type, bipolar type, and MOS type integrated circuits in a semiconductor substrate, isolated regions arranged in the semiconductor substrate must have good isolation characteristics.

It is an object of the present invention to provide an integrated semiconductor device in which the degree of integration of CCD type, bipolar type, and MOS type integrated circuits in one semiconductor chip is extended to permit complementary devices to be included.

It is still another object of the present invention to provide a method of making the above integrated device without using complicated processing.

According to one aspect of the present invention, the integrated semiconductor device initially defined is characterized by: a charge coupled device provided on the semiconductor substrate; a well region of the first conductivity type in the second epitaxial layer island; and CMOS type transistors provided in the second epitaxial layer island.

According to another aspect of the invention, there is provided a method of making an integrated semiconductor device comprising the steps of:
preparing a semiconductor substrate of a first conductivity type having a low impurity concentration;
selectively forming recessed portions in the semiconductor substrate;
diffusing a dopant impurity of a second conductivity type into each of the recessed portions to provide a buried layer having a high impurity concentration;
epitaxially growing a semiconductor layer of the second conductivity type over the substrate surface so as to fill the recessed portions therewith;
subjecting the substrate surface to lapping and polishing to provide first and second epitaxial layer islands of the second conductivity type in respective recessed portions;
forming a well region in the second epitaxial layer island;
forming a collector contact of the second conductivity type of a bipolar transistor in the first epitaxial layer island so as to overlap the buried layer;
forming a field oxide film in the semiconductor substrate to define device elements;
subsequently forming a gate insulating film and a conductive layer on the semiconductor substrate, the well region and the first epitaxial layer island at the same time, respectively;
patterning the conductive layer and the gate insulating film to provide a charge coupled device on the semiconductor substrate and also to form a gate structure on the second epitaxial layer island and the well region; and
introducing dopant impurities into the first and second epitaxial layer islands and the well region to provide the bipolar transistor and CMOS transistors.

This invention can be more fully understood from the following detailed description when taken in conjunction with the accompanying drawings, in which:
Figure 1 is a section view schematically showing an integrated semiconductor device according to a first embodiment of the present invention;
Figures 2A to 2E are sectional views schematically showing fabrication processes for the integrated semiconductor device in Figure 1;

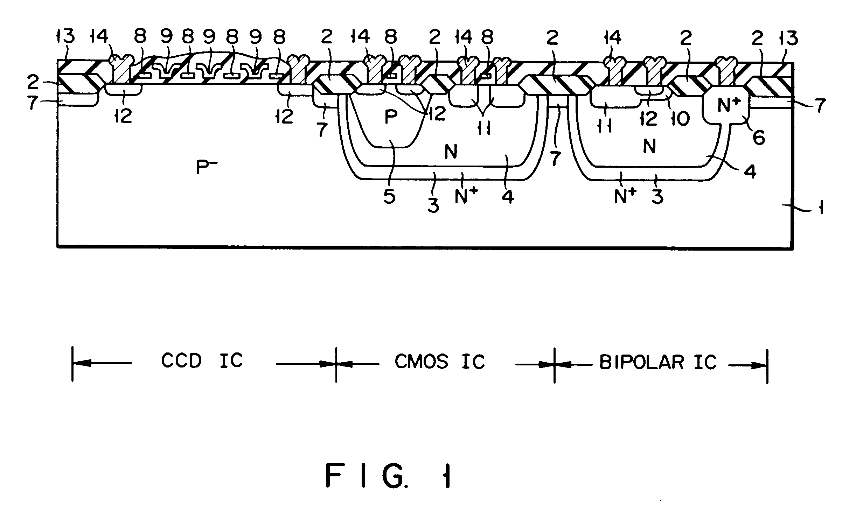

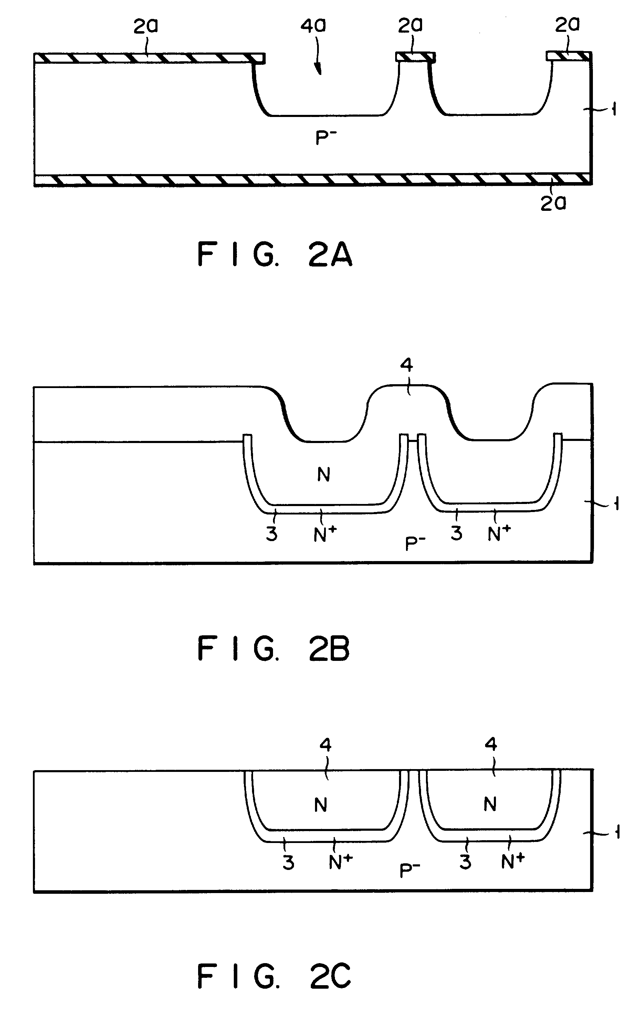

An integrated semiconductor device according to the first embodiment of the present invention is shown in Figure 1, and fabrication processes for the integrated circuit device are shown in Figs. 2A to 2E.

In Fig. 1, the semiconductor integrated circuit device comprises N-type epitaxial layer islands 4 which are provided so as to be exposed on a major surface of a P⁻-type silicon substrate 1, field oxide layers 2 each surrounding a periphery of the exposed surface of each epitaxial layer, N⁺-type buried layers 3 each being connected to each field oxide layer 2 and covering each epitaxial layer 4, a CCD type IC provided on a P⁻-type surface layer of the substrate 1, a bipolar type IC disposed in epitaxial layers 4, and a CMOS type IC provided in another epitaxial layers 4. Note that Fig. 1 is a sectional view in which an arrangement of the CCD type, bipolar type, and CMOS type ICs is partially represented as a typical example.

A method of making the integrated circuit device according to the first embodiment will be described below with reference to Figs. 2A to 2E, and the detailed structure of the circuit will also be described.

The P⁻-type silicon substrate 1 having a resistivity of about 50 Ω·cm is thermally oxidized at a temperature of 1,000°C to form a silicon oxide film 2a having a thickness of 1 µm. The oxide film 2a is selectively removed by lithography techniques to provide both an intended region for forming a CMOS type IC (hereinafter referred to as CMOS portion) and an intended region for forming a bipolar type IC (hereinafter referred to as bipolar portion). Using the remaining oxide film 2a as a mask, the P⁻-type silicon substrate 1 is etched by about 10 µm with a solution of hydrofluoric acid/nitric acid system, thereby providing recessed island portions 4a (Fig. 2A).

The inner surface of each recessed portion 4a is doped with an N-type impurity of Sb (antimony) to form the N⁺-type buried layer 3 having a high impurity concentration represented by a sheet resistance of about 20 Ω/□. After the silicon oxide film 2a is etched away, P (phosphorus) doped N-type epitaxial layer 4 having a thickness of 10 µm and a resistivity of 2 Ω·cm is epitaxially grown on the substrate surface to fill the recessed portions 4a therewith (Fig. 2B).

The N-type epitaxial layer is removed by about 12 µm, using lapping and polishing techniques. In this case, the epitaxial layer is removed until the substrate surface is completely exposed (Fig. 2C).

A P-type well diffusion layer 5 and an N⁺-type diffusion layer 6 for a collector contact having a high impurity concentration are formed by an impurity diffusion process at a temperature of 1,100°C in the epitaxial layers 4 of the CMOS portion and the bipolar portion, respectively. The substrate surface is thermally oxidized at a temperature of 1,000°C to form a silicon oxide film having a thickness of 90 nm (900 Å) (not shown), on which a silicon nitride film having a thickness of 200 nm (2,000 Å) is deposited by LPCVD techniques. The silicon nitride film is removed except for active regions. In order to prevent unwanted field inversion, B (boron) ions are implanted into the P⁻-type silicon substrate through openings formed by selectively removing the silicon nitride film. Thereafter, LOCOS oxidation is performed for the substrate surface to form field oxide films 2 having a thickness of 800 nm (8,000 Å) thereby providing a P-type inversion prevention layer 7 just under the filed oxide films 2.

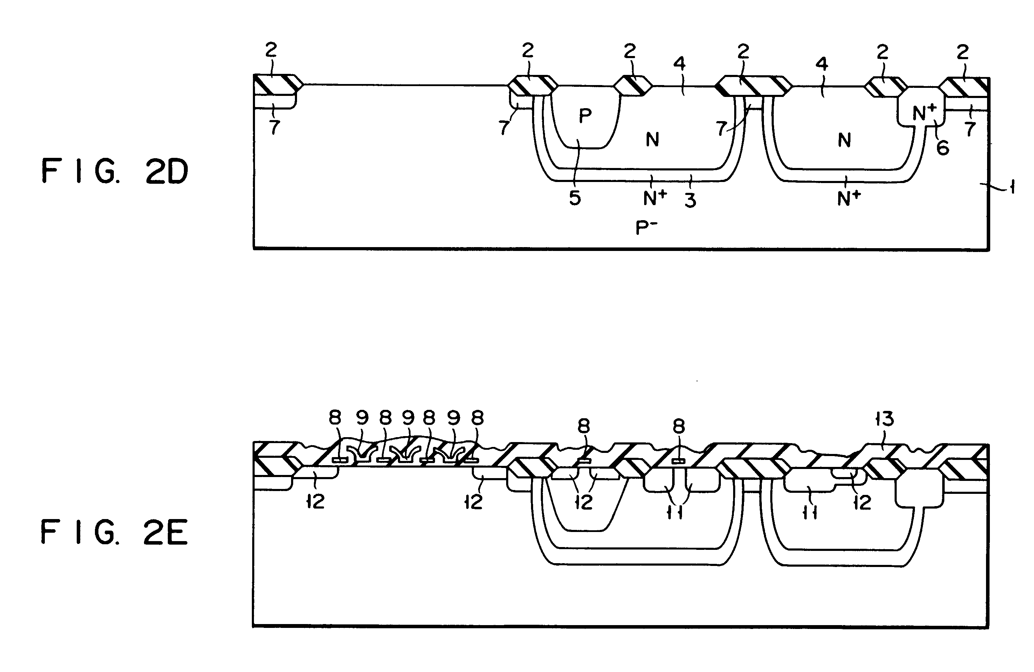

The silicon nitride film (thickness of 200 nm (2,000 Å) used as an anti-oxidation mask and the silicon oxide film (thickness of 90 nm (900 Å) are removed (Figure 2D).

A first gate oxide film having a thickness of 70 nm (700 Å) are formed at a temperature of 1,000°C on both an intended region for forming a CCD type IC (hereinafter referred to as CCD portion), i.e., the P⁻-type surface layer of the substrate 1 and the exposed surface of the epitaxial layers 4 of the CMOS portion. Thereafter, P (phosphorus) ions and B (boron) ions are respectively implanted into the CCD portion and the CMOS portion to control a threshold voltage Vth. Thereafter, an N⁺-type first polysilicon film having a thickness of 400 nm (4,000 Å) and containing a high impurity concentration of P (phosphorus) is deposited on the substrate. Using a resist layer as a mask, the polysilicon film is etched by RIE (Reactive Ion Etching) techniques to provide first gate electrodes 8 of the CCD type IC and gate electrodes 8 of the MOSFET. After the exposed first gate oxide film is removed, a second gate oxide film having a thickness of 70 nm (700 Å) is formed on the substrate surface at a temperature of 1,000°C. B (boron) ions are implanted into the CCD portion, and B (boron) ions are also implanted into the bipolar portion so as to provide an inner base layer 10. Thereafter, an N⁺-type second polysilicon film containing at a high impurity concentration of P (phosphorus) and having a thickness of 400 nm (4,000 Å) is deposited on the substrate surface.

Note that the above N⁺-type first and second polysilicon films are formed by, for example, depositing a non-doped polysilicon film on the substrate surface, forming a P (phosphorus) layer, serving as an impurity source, on the polysilicon film, and diffusing the P (phosphorus) into the polysilicon film respectively.

Using a resist layer as a mask, the second polysilicon film is etched by RIE (Reactive Ion Etching) techniques to provide second gate electrodes 9 of the CCD portion. Subsequently, As (arsenic) ions are selectively implanted into the substrate to provide predetermined regions of the CCD portion, source and drain regions of an NMOSFET in the CMOS portion, and an emitter region of the bipolar portion, respectively. The surface of the substrate is then oxidized at a temperature of 900°C in a dry O₂ atmosphere. Thereafter, B (boron) ions are selectively implanted into the substrate to provide source and drain regions of a PMOSFET in the CMOS portion and an external base region of the bipolar portion. The substrate surface is covered with an insulating film 13 composed of a silicon oxide film containing no impurity and a BPSG film. Thereafter, melting and phosphorus gettering treatments are performed at a temperature of 950°C. P⁺-type diffused regions 11 and N⁺-type diffused regions 12 are activated by these treatments (Fig. 2E).

Using a resist layer as a mask, insulating film 13 is etched by RIE techniques to form contact holes. After an Aℓ-Si (1%) film having a thickness of 800 nm (8,000 Å) is deposited on the surface of the substrate, it is selectively etched by RIE techniques to form electrode wiring films 14. Finally, a forming gas treatment is performed for the substrate at a temperature of 450°C (Fig. 1).

According to this embodiment, the CCD type, bipolar type, and CMOS type integrated circuits are provided in the P⁻-type surface layer of the substrate, one N-type epitaxial layer 4- surrounded by the N⁺-type buried layer 3, and the other epitaxial layer 4, respectively. Since the N⁺-type buried layers 3 are provided around the N-type epitaxial layers 4, this structure may prevent an unwanted latch-up phenomenon caused by a parasitic thyristor.

Though the thickness of each epitaxial layer is about 10 µm, it is possible to change its thickness by varying lapping and polishing amounts of the N-type epitaxial layer and the P⁻-type substrate. Accordingly, bipolar type semiconductor elements with various breakdown voltages may be made without a complicated process.

As has been described above, in the semiconductor integrated circuit device according to the present invention, epitaxial layer islands surrounded by both the field insulating layer and the buried layer having the high impurity concentration are located in the substrate having the low impurity concentration so as to be isolated from one another. This integrated circuit device can be produced by the method of the present invention without using complicated processing. Therefore, CCD type, bipolar type, and MOS type (CMOS, NMOS) integrated circuits can be efficiently provided in the single chip. Since these integrated circuits are formed on a single chip, various problems (e.g., countermeasures for system, high-speed operation, miniaturization for equipment, reduction in the number of pins, and low power consumption), which are subjects of conventional multi-chip techniques, can be eliminated.

It is further understood by those skilled in the art that the foregoing description is of preferred embodiments of the disclosed device and that various changes and modifications may be made in the invention without departing from the scope thereof which is defined by the appended claims.

Reference signs in the claims are intended for better understanding and shall not limit the scope.

## Claims

1. An integrated semiconductor device comprising: a semiconductor substrate of a first conductivity type having a low impurity concentration; first and second expitaxial layer islands (4) of a second conductivity type provided in the semiconductor substrate (1) so as to be exposed to the substrate surface; a buried layer (3) of the second conductivity type having a high impurity concentration the buried layer (3) being provided in the semiconductor substrate (1) and surrounding each of the first and second epitaxial layer islands (4); a field oxide film (2) formed in the semiconductor substrate (1) so as to surround the periphery of the first and second epitaxial layer islands (4); and a bipolar transistor formed in the first epitaxial layer island (4); characterized by: a charge coupled device provided on the semiconductor substrate (1); a well region (5) of the first conductivity type in the second epitaxial layer island (4); and CMOS type transistors provided in the second epitaxial layer island (4).

2. An integrated semiconductor device according to claim 1;
characterized in that said CMOS type transistors are electrically isolated from said CCD by a field oxide film (2).

3. An integrated semiconductor device according to any preceding claim;
characterized in that a collector contact (6) of second conductivity type having a high impurity concentration is provided so as to overlap said buried layer (3).

4. An integrated semiconductor device according to any preceding claim;
characterized in that an inversion prevention layer (7) having the same conductivity as that of said semiconductor substrate (1) is provided beneath said field oxide film (2).

5. A method of making an integrated semiconductor device comprising the steps of:
preparing a semiconductor substrate (1) of a first conductivity type having a low impurity concentration;
selectively -forming recessed portions (4a) in the semiconductor substrate (1);
diffusing a dopant impurity of a second conductivity type into each of the recessed portions (4a) to provide a buried layer (3) having a high impurity concentration;
epitaxially growing a semiconductor layer (4) of the second conductivity type over the substrate surface so as to fill the recessed portions (4a) therewith;
subjecting the substrate surface to lapping and polishing to provide first and second epitaxial layer islands (4) of the second conductivity type in respective recessed portions (4a);
forming a well region (5) in the second epitaxial layer island (4);
forming a collector contact (6) of the second conductivity type of a bipolar transistor in the first epitaxial layer island (4) so as to overlap the buried layer (3);
forming a field oxide film (2) in the semiconductor substrate (1) to define device elements;
subsequently forming a gate insulating film and a conductive layer on the semiconductor substrate (1), the well region (5) and the first epitaxial layer island (4) at the same time, respectively;
patterning the conductive layer and the gate insulating film to provide a charge coupled device on the semiconductor substrate (1) and also to form a gate structure on the second epitaxial layer island (4) and the well region (5); and
introducing dopant impurities into the first and second epitaxial layer islands (4) and the well region (5) to provide the bipolar transistor and CMOS transistors.

6. A method of making an integrated semiconductor device according to claim 5;
characterized in that an insulating film (13) composed of an undoped oxide film and a BPSG film is deposited over said semiconductor substrate (1) after forming respective active device regions therein, and that said semiconductor substrate (1) is heated to a desired temperature to perform a surface-planarization treatment for said BPSG film.

## Patentansprüche

1. Integrierte Halbleitervorrichtung, aufweisend:
- ein Halbleitersubstrat eines ersten Leitfähigkeitstyps, mit einer niedrigen Störatomkonzentration;
- erste und zweite epitaktische Schichtinseln (4) eines zweiten Leitfähigkeitstyps, die im Halbleitersubstrat (1) vorgesehen sind, derart, daß sie der Substratoberfläche ausgesetzt sind;
- eine vergrabene Schicht (3) des zweiten Leitfähigkeitstyps, mit einer hohen Störatomkonzentration, wobei die vergrabene Schicht (3) im Halbleitersubstrat (1) vorgesehen ist und jede der ersten und zweiten epitaktischen Schichtinseln (4) umgibt;
- einen Feldoxidfilm (2), der auf dem Halbleitersubstrat (1) gebildet ist, derart, daß er die Peripherie der ersten und zweiten epitaktischen Schichtinseln (4) umgibt; und
- einen bipolaren Transistor, der in der ersten epitaktischen Schichtinsel (4) gebildet ist;
**gekennzeichnet** durch:
- eine ladungsgekoppelte Vorrichtung auf dem Halbleitersubstrat (1);
- einen Wannenbereich (5) des ersten Leitfähigkeitstyps in der zweiten epitaktischen Schichtinsel (4); und
- CMOS-Transistoren, die in der zweiten epitaktischen Schichtinsel (4) vorgesehen sind.

2. Integrierte Halbleitervorrichtung nach Anspruch 1, dadurch **gekennzeichnet** , daß die CMOS-Transistoren elektrisch von der ladungsgekoppelten Vorrichtung (CCD) durch einen Feldoxidfilm (2) getrennt sind.

3. Integrierte Halbleitervorrichtung nach irgendeinem vorhergehenden Anspruch,
dadurch **gekennzeichnet**, daß ein Kollektorkontakt (6) des zweiten Leitfähigkeitstyps, der eine hohe Störatomkonzentration aufweist, so vorgesehen ist, daß er die vergrabene Schicht (3) überlappt.

4. Integrierte Halbleitervorrichtung nach irgendeinem der vorhergehenden Ansprüche,
dadurch **gekennzeichnet** , daß eine Inversionsverhinderungsschicht (7) mit der gleichen Leitfähigkeit wie der des Halbleitersubstrats (1) unterhalb des Feldoxidfilms (2) vorgesehen ist.

5. Verfahren zur Herstellung einer integrierten Halbleitervorrichtung, das folgende Schritte aufweist:
- Herstellen eines Halbleitersubstrats (1) eines ersten Leitfähigkeitstyps, das eine niedrige Störatomkonzentration besitzt;
- selektives Ausbilden von ausgesparten Abschnitten (4a) im Halbleitersubstrat (1);
- Eindiffundieren von Dotierstöratomen eines zweiten Leitfähigkeitstyps in jeden der ausgesparten Abschnitte (4a), um eine vergrabene Schicht (3) anzubringen, die eine hohe Störatomkonzentration besitzt;
- epitaktisches Aufwachsen einer Halbleiterschicht (4) des zweiten Leitfähigkeitstyps über der Substratoberfläche, derart, daß die ausgesparten Abschnitte (4a) mit der Schicht gefüllt werden;
- Unterziehen der Substratoberfläche dem Läppen und Polieren, um erste und zweite epitaktische Schichtinseln (4) de zweiten Leitfähigkeitstyps in entsprechend ausgesparten Abschnitten (4a) anzubringen;
- Ausbilden eines Wannenbereichs (5) in der zweiten epitaktischen Schichtinsel (4);
- Ausbilden eines Kollektorkontakts (6) des zweiten Leitfähigkeitstyps eines bipolaren Transistors in der ersten epitaktischen Schichtinsel (4), derart, daß die vergrabene Schicht (3) überlappt wird;
- Ausbilden eines Feldoxidfilms (2) im Halbleitersubstrat (1), um Vorrichtungselemente zu definieren;
- anschließendes Ausbilden eines Gatterisolierfilms und einer leitenden Schicht gleichzeitig jeweils auf dem Halbleitersubstrat (1), dem Wannenbereich (5) und der ersten epitaktischen Schichtinsel (4);
- Bemustern der leitenden Schicht und des Gatterisolierfilms, um eine ladungsgekoppelte Vorrichtung auf dem Halbleitersubstrat (1) zu schaffen und um weiter eine Gatterstruktur auf der zweiten epitaktischen Schichtinsel (4) sowie dem Wannenbereich (5) auszubilden; und
- Einbringen von Dotierstoffen in die erste und zweite epitaktische Schichtinsel (4) sowie in den Wannenbereich (5), um den bipolaren Transistor und die CMOS-Transistoren zu schaffen.

6. Verfahren zur Herstellung einer integrierten Halbleitervorrichtung nach Anspruch 5, dadurch **gekennzeichnet** , daß ein Isolierfilm (13), bestehend aus einem nichtdotierten Oxidfilm und einem BPSG-Film, nach dem Ausbilden entsprechender aktiver Vorrichtungsbereiche darin, über dem Halbleitersubstrat (1) aufgebracht wird, und daß das Halbleitersubstrat (1) auf eine gewünschte Temperatur erwärmt wird, um eine Oberflächenplanierbehandlung des BPSG-Films durchzuführen.

## Revendications

1. Dispositif à semiconducteur intégré comprenant :
un substrat semiconducteur d'un premier type de conductivité présentant une concentration en impureté faible ; des premier et second îlots de couche épitaxiale (4) d'un second type de conductivité prévus dans le substrat semiconducteur (1) de manière à être à nu au niveau de la surface du substrat ; une couche enterrée (3) du second type de conductivité présentant une concentration en impureté élevée, la couche enterrée (3) étant prévue dans le substrat semiconducteur (1) et entourant chacun des premier et second îlots de couche épitaxiale (4) ; un film d'oxyde de champ (2) formé dans le substrat semiconducteur (1) de manière à entourer la périphérie des premier et second îlots de couche épitaxiale (4) ; et un transistor bipolaire formé dans le premier îlot de couche épitaxiale (4), caractérisé par : un dispositif à couplage de charge (CCD) prévu sur le substrat semiconducteur (1) ; une région de puits (5) du premier type de conductivité dans le second îlot de couche épitaxiale (4) et des transistors du type CMOS prévus dans le second îlot de couche épitaxiale (4).

2. Dispositif à semiconducteur intégré selon la revendication 1, caractérisé en ce que lesdits transistors du type CMOS sont isolés électriquement dudit CCD par un film d'oxyde de champ (2).

3. Dispositif à semiconducteur intégré selon l'une quelconque des revendications précédentes, caractérisé en ce qu'un contact de collecteur (6) d'un second type de conductivité présentant une concentration en impureté élevée est prévu de manière à chevaucher ladite couche enterrée (3).

4. Dispositif à semiconducteur intégré selon l'une quelconque des revendications précédentes, caractérisé en ce qu'une couche d'empêchement d'inversion (7) présentant la même conductivité que celle dudit substrat semiconducteur (1) est prévue au-dessous dudit film d'oxyde de champ (2).

5. Procédé de fabrication d'un dispositif à semiconducteur intégré, comprenant les étapes de :
préparation d'un substrat semiconducteur (1) d'un premier type de conductivité présentant une concentration en impureté faible ;
formation de manière sélective de parties évidées (4a) dans le substrat semiconducteur (1) ;
diffusion d'une impureté de dopant d'un second type de conductivité dans chacune des parties évidées (4a) de manière à constituer une couche enterrée (3) présentant une concentration en impureté élevée ;
croissance épitaxiale d'une couche semiconductrice (4) du second type de conductivité sur la surface de substrat de manière à remplir les parties évidées (4a) avec ;
soumission de la surface de substrat à un érodage et un polissage afin de constituer des premier et second îlots de couche épitaxiale (4) du second type de conductivité dans les parties évidées respectives (4a) ;
formation d'une région de puits (5) dans le second îlot de couche épitaxiale (4) ;
formation d'un contact de collecteur (6) du second type de conductivité d'un transistor bipolaire dans le premier îlot de couche épitaxiale (4) de manière à ce qu'il chevauche la couche enterrée (3);
formation d'un film d'oxyde de champ (2) dans le substrat semiconducteur (1) afin de définir des éléments de dispositif;
formation consécutive d'un film d'isolation de grille et d'une couche conductrice respectivement sur le substrat semiconducteur (1), sur la région de puits (5) et sur le premier îlot de couche épitaxiale (4) en même temps ;
conformation de la couche conductrice et du film d'isolation de grille afin de constituer un dispositif à couplage de charge sur le substrat semiconducteur (1) et également afin de former une structure de grille sur le second îlot de couche épitaxiale (4) et la région de puits (5) ; et
introduction d'impuretés de dopant dans les premier et second îlots de couche épitaxiale (4) et dans la région de puits (5) de manière à constituer le transistor bipolaire et les transistors CMOS.

6. Procédé de fabrication d'un dispositif à semiconducteur intégré selon la revendication 5, caractérisé en ce qu'un film isolant (13) constitué par un film d'oxyde non dopé et par un film en BPSG est déposé sur ledit substrat semiconducteur (1) après formation de régions de dispositif actif respectives dedans et en ce que ledit substrat semiconducteur (1) est chauffé jusqu'à une température souhaitée afin de réaliser un traitement de planarisation de surface pour ledit film en BPSG.
